# EUROPEAN PATENT APPLICATION

(11) **EP 4 756 483 A1**
(43) Date of publication of application: **10.06.2026**
(21) Application number: 25218157.3
(22) Date of filing: 24.11.2025
(51) Int. Cl.: G01S 7/03, G01S 13/87, H01P 3/00, G01S 13/931

(54) **MODULAR LOW LOSS INTERPOSERS**

(30) Priority: 04.12.2024 US 202418968511
(71) Applicant: NXP USA, Inc., Austin, TX 78735 (US)
(72) Inventor: ZANATI, Abdellatif, 5656AG Eindhoven (NL); CARTER, Robert Fred, 5656AG Eindhoven (NL)
(74) Representative: Schwarzweller, Thomas

(57) **Abstract**

Radiofrequency systems for use in advanced driver assistance systems (ADAS) can include a mixture of high frequency (e.g., above 1 GHz) analog and components and lower-frequency digital devices mounted on one main circuit board. Cost savings can be achieved by providing high-frequency signal paths on an interposer circuit board that is mounted to the main circuit board and couples devices requiring high-frequency signalling (e.g., distributing a local oscillator signal to several devices forming part of a cascaded radar system). The interposer is fabricated from special purpose materials suitable for routing high frequency signals with low loss, while the main circuit board can be fabricated from commodity materials suitable for lower frequency applications.

## Description

### TECHNICAL FIELD

Embodiments of the subject matter described herein relate to radiofrequency circuits and systems.

### BACKGROUND

Circuits that require distribution of high-frequency (e.g., 1 GHz and above) signals between multiple components are becoming increasingly common for industrial and consumer applications. For instance, many passenger automobiles are equipped with advanced driver assistance (ADAS) systems which often include radar transceivers and processors that enable obstacle avoidance, adaptive cruise control, and other crash avoidance features. Cascaded radar systems, in which the operation of multiple individual radar transceivers are synchronized with each other can be a cost-effective approach to providing enhanced radar performance by enabling features such as increased detection range and improved beamforming.

### SUMMARY

In an example embodiment, a system includes a circuit substrate providing a first set of electrical interconnects; a first set of electronic devices and a second set of electronic devices that are mechanically coupled to the circuit substrate, where the first set of electronic devices is configured to communicate with the second set of electronic devices via the first set of electrical interconnects; and an interposer substrate mechanically and electrically coupled to the circuit substrate that provides a second set of electrical interconnects configured to route radiofrequency (RF) signals to the second set of electronic devices; where the interposer substrate is characterized by a loss tangent value for RF signals at a desired operational frequency of the second set of electronic devices; and where the circuit substrate is characterized by a second loss tangent value for RF signals at the desired operational frequency of the second set of electronic devices that is greater than the first attenuation value.

### BRIEF DESCRIPTION OF THE DRAWINGS

The present disclosure is illustrated by way of examples, embodiments and the like and is not limited by the accompanying figures, in which like reference numbers indicate similar elements. Elements in the figures are illustrated for simplicity and clarity and have not necessarily been drawn to scale. The figures along with the detailed description are incorporated and form part of the specification and serve to further illustrate examples, embodiments and the like, and explain various principles and advantages, in accordance with the present disclosure, wherein:
**FIG.** 1 is a schematic plan view of a system according to one or more embodiments that includes a low-loss RF interposer.
FIG. 2A is schematic cross-sectional view of the system of FIG. 1.
FIG. 2B is a schematic cross-sectional view of a system related to the system of FIG. 2A.
FIG. 2C is a schematic cross-sectional view of a system related to the system of FIG. 2A.
FIG. 3A is a schematic plan view of an RF interposer suitable for use in one or more embodiments that includes an RF coupler formed using substrate-integrated waveguide (SIW) techniques.
FIG. 3B is a schematic plan view of the interposer of FIG. 3A.
**FIG.** 4 is a schematic plan view of an RF interposer suitable for use in one or more embodiments that includes an RF coupler related to the coupler of FIG. 3A and 3B that includes an integrated amplifier.

### DETAILED DESCRIPTION

The following detailed description provides examples for the purposes of understanding and is not intended to limit the invention or the application and uses of the same. Furthermore, there is no intention to be bound by any expressed or implied theory presented in the preceding technical field, background, or the following detailed description.

For simplicity and clarity of illustration, elements in the Drawings are not necessarily drawn to scale. For example, the dimensions of some of the elements or regions in the figures may be exaggerated relative to other elements or regions to help improve understanding of embodiments of the invention. Directional references such as "top," "bottom," "left," "right," "above," "below," and so forth, unless otherwise stated, are not intended to require any preferred orientation, and are made with reference to the orientation of the corresponding figure or figures for purposes of illustration. In addition, the Figures and Detailed Description may omit well-known and conventional features for clarity.

Cascaded radar systems in which a single local oscillator (LO) signal is distributed to multiple synchronized transceivers which operate coherently have been adapted for use in ADAS systems for passenger automobiles and other applications where system performance often must be balanced against manufacturing costs, space constraints, and ease of integration with other electronic and mechanical systems. In order to address these constraints, multiple radar transceivers can be packaged on a circuit board that is directly attached to a 3D antenna assembly that contacts a top or bottom surface of the circuit board.

Such radar systems typically employ local oscillator frequencies in excess of 10 GHz. However, many commonly used circuit board materials (e.g., epoxy-glass composites such as FR-4) exhibit high losses at signal frequencies in the GHz range and frequency-dependent losses which can also result in unwanted signal dispersion. These properties can place limits on the maximum length of signal distribution lines and can make it difficult to achieve phase-matching between multiple signal lines, which is usually a requirement for cascaded radar systems in which the LO signals received at each transceiver should be in phase with each other. One solution to these challenges is to use a different circuit board material that has better loss characteristics in the selected frequency band. However, this can dramatically raise system costs.

Accordingly, devices and methods disclosed herein enable the design, fabrication, and integration of cascaded radar systems and related systems which reduce the need for expensive low-loss circuit board materials by forming important signal-routing on modular interposers that are easily connected to larger circuit boards that use more cost-effective materials.

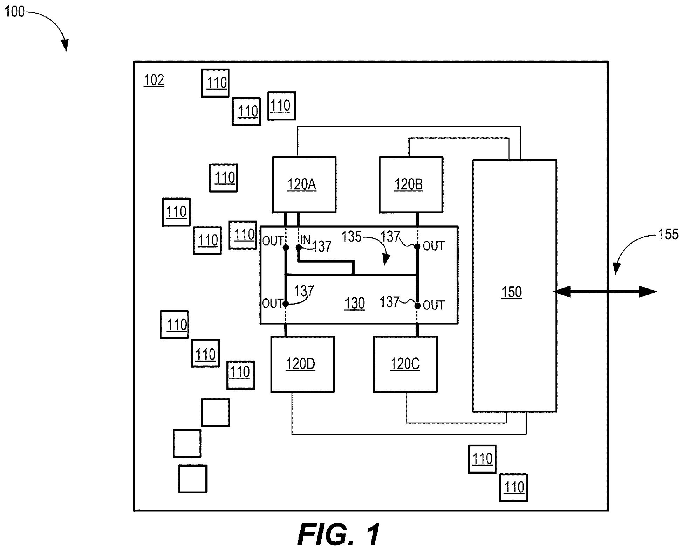

Along these lines, FIG. 1 shows a simplified schematic top view of an example radar system. The system 100 is built on a carrier 102 (e.g., a printed circuit board or other suitable substrate) and includes a first set of components 110 and a second set of components 120 which can be interconnected to each other and to a processor 150. The processor 150 includes a communication interface 155 which can be used to connect the system 100 to other devices and systems. For example, the processor 150 may provide signals indicating detection of an obstacle to an ADAS system controller in a passenger vehicle. The first set of components 110 can be any components which do not require low-loss high frequency signal paths, while the second set of components 120 are components that require low-loss signal distribution at high frequencies (e.g., above 1 GHz). In the example, of FIG. 1, the system 100 includes four radar transceivers 120A, 120B, 120C, and 120D (depicted as individually packaged devices that are mechanically and electrically coupled to the substrate 102. The radar transceiver 120A can be configured as a primary transceiver that is configured to distribute a local oscillator (LO) signal and the transceivers 120B, 120C, 120D can be secondary transceivers configured to receive an externally-generated LO signal.

The system 100 includes an interposer 130 that includes a 4-way RF coupler 135 (which may also be referred to as a power divider or splitter) that is configured to split a signal (e.g., an LO signal generated by the transceiver 120A) received at an input port 136 of the coupler 135 (labeled 'IN') into four individual signals at four respective output ports 137 of the coupler (labeled 'OUT'). The RF coupler 135 is depicted as microstrip coupler, but any suitable couplers and combination thereof can be used, including stripline couplers, waveguide couplers, and the like, as nonlimiting examples.

The interposer 130 is fabricated from materials with suitably low loss and dispersion in the selected operational frequency band. The material of the interposer 130 can be chosen such that it is possible to ensure that the effective path lengths between the input port 136 of the RF coupler 135 and each output port 137 of the RF coupler 135 are equal (and thus that the phase of the LO signal at each output port 137 of the coupler 135 is equal to within an acceptable margin of error such as 5° or less at a selected operating frequency or operating frequency band of the RF coupler 135. Suitable dielectric materials for use in an interposer such as the interposer 130 include, as non-limiting examples, PTFE, other low-loss polymeric materials, various ceramics, and the like. For instance, PTFE-based circuit boards can exhibit loss tangent values well below 0.01, or even 0.001, at frequencies well above 1 GHz, including frequencies used for LO signals in automotive radars.

In one or more embodiments, an interposer (e.g., the interposer 130) is a circuit board provided with conventional electrical contacts that allow the interposer to be mechanically and electrically coupled to a larger circuit board or other substrate (e.g., the carrier 102) using conventional techniques. For example, the interposer 130 may be provided with solder balls in a ball-grid array (BGA) arrangement, the interposer 130 may have contacts compatible with a surface-mount solder reflow process, or the like, as nonlimiting examples.

It will be understood that the system 100 is a non-limiting example for purposes of illustration. For instance, nothing herein is intended to limit the use of embodiments to systems that include radar transceivers and the distribution of LO signals. Along similar lines, interposers according to embodiments disclosed herein can include any suitable number of signal paths and devices (including, as nonlimiting examples, clock distribution paths, clock buffers, and the like) as well as any other suitable active or passive components.

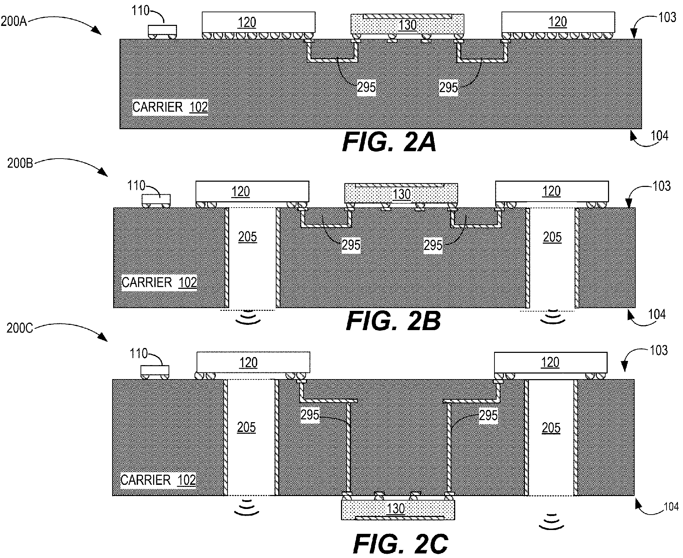

FIG. 2A, FIG. 2B, and FIG. 2C are cross-sectional views illustrating features of systems such as the system 100 in one or more embodiments. In the system 200A, two devices 120 (e.g., radar transceiver chips) are shown mounted on the carrier 102 and coupled to the interposer 130 (depicted as a circuit board bonded to the carrier 102 via solder balls) via electrical interconnects 295 disposed on and within the carrier 102. In one or more embodiments, such connections are made entirely via conductive traces on the surface of a carrier such as the top surface 103 of the carrier 102 (or the bottom surface 104). A device 110 is also shown mounted on top surface 103 the carrier 102.

In the system 200B, the carrier 102 is modified to include launching structures 205 underneath each device 205. The launching structures 205 extend through the carrier 102 and include conductive sidewalls that are dimensioned and arranged to guide wireless signals emitted or received by each device 120 (e.g., radar pulses or radar return signals) away from (or toward) each device 120 and the carrier 102. In one or more embodiments, a planar or three-dimensional antenna assembly can be coupled to the surface of the carrier 102 beneath the devices 120.

In the system 200C, interposer 130 is mounted on the bottom surface 104 of the carrier 102 beneath the device 120 and in between the two launching structures 205. In one or more embodiments, an antenna structure or other can be mounted on bottom surface of the carrier 102 along with the interposer 130. The antenna structure or fixture can include a recess or opening disposed over the interposer 130 when the antenna structure or fixture is coupled to the carrier 102.

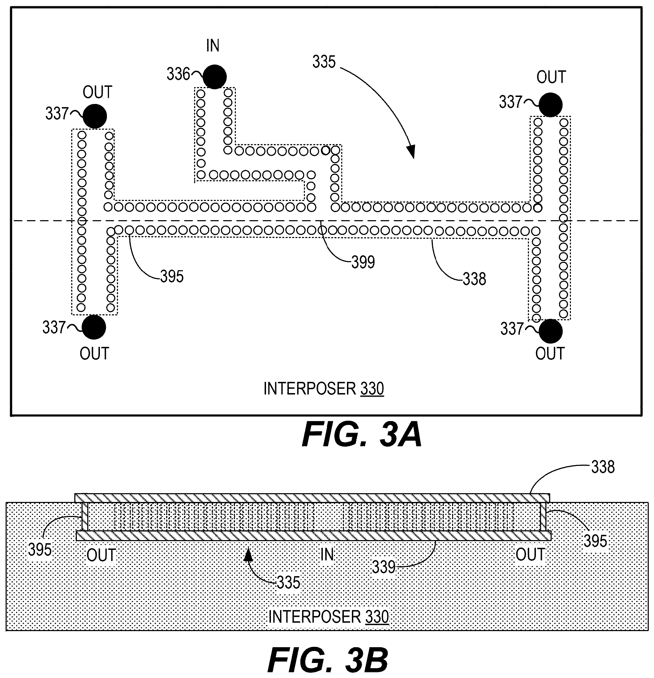

Interposers according to one or more embodiments can include any suitable structures for coupling RF signals (e.g., LO signals) between devices such as radar transceivers (e.g., device 120). For instance, FIG. 3A is a plan view of an interposer 330 with an RF coupler 335 based on a substrate-integrated waveguide (SIW). The RF coupler 335 guides RF signals within the volume of the interposer 330 via a waveguide with sidewalls defined by metallized vias 395 which are arranged such they behave similarly to a solid electrically conductive surface over the designed operational bandwidth of the RF coupler 335. The RF coupler 335 is covered above and below the vias 395 with a ground plane or other suitably conductive surface. The dashed outline indicates the footprint of a metallized surface 338 not directly shown in FIG. 3A that forms a top surface of the RF coupler 335 FIG. 3B is a cross-sectional view of the coupler 335 along the line 399 of FIG. 3A showing the location of the input port 336 and output ports 337 as well as the top surface 338 and bottom surface 339 of the RF coupler 335 in relation to the vias 395 that form sidewalls of the RF coupler 335

It should be understood that the RF coupler 335 is depicted as an SIW coupler as a nonlimiting example and that any suitable coupling structures can be used in one or more embodiments. For instance, a dielectric waveguide coupler can be used together with suitable transition structures for coupling signals between metallic waveguides and other interconnects and the waveguide coupler. It will be understood that nothing herein is intended to limit embodiments to any particular coupler or interconnect architectures. Accordingly, it will be understood that nonlimiting examples of suitable structures include stripline structures, dielectric waveguide structures, conductive waveguide structures, coaxial structures and any suitable combination of such structures and the like.

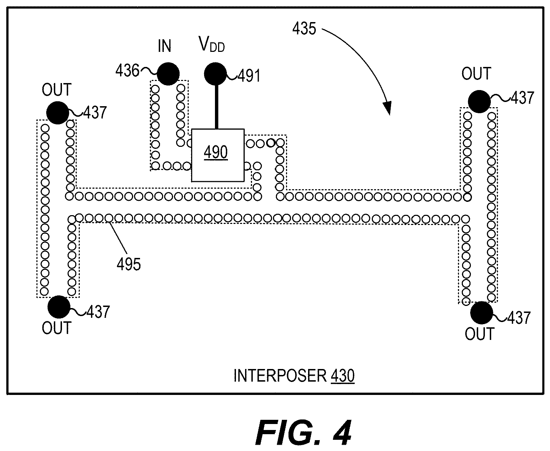

As above, interposers according to one or more embodiments can include additional active devices. For instance, FIG. 4 shows an interposer includes an amplifier 490 that is coupled to the input port 436 of the RF coupler 435 depicted as an SIW coupler with sidewalls formed using vias 495 (e.g., vias 395). The amplifier 490 is and configured to receive an LO signal via the input port 436 and amplify it before coupling the amplified LO signal to the output ports 437 of the RF coupler 435. In one or more embodiments, an amplifier such as the amplifier 490 or other active device can be configured to receive power via a supply voltage terminal (e.g., the port 491 labeled 'V_{DD}' in FIG. 4) configured to be coupled to a carrier (e.g., a carrier 102) to which the interposer is connected. Similarly, an interposer according to one or more embodiments can include any other appropriate connections and signal distribution (e.g., a ground or other reference voltage connection as one nonlimiting example).

It will be understood that the interposer 435 is intended as a non-limiting example. Along these lines, an interposer according to one or more embodiments can include multiple active devices such as the amplifier 490. Similarly, in one or more embodiments, an interposer includes passive devices (e.g., capacitors, inductors, resistors, and the like).

### EXAMPLES

Features of embodiments may be understood by way of one or more of the following examples:
Example 1: A system, device, or method that includes: a circuit substrate providing a first set of electrical interconnects. A first set of electronic devices and a second set of electronic devices are mechanically coupled to the circuit substrate. The first set of electronic devices is configured to communicate with the second set of electronic devices via the first set of electrical interconnects. An interposer substrate is mechanically and electrically coupled to the circuit substrate and provides a second set of electrical interconnects configured to route radiofrequency (RF) signals to the second set of electronic devices. The interposer substrate is characterized by a first loss tangent value for RF signals at a selected operational frequency of the second set of electronic devices. The circuit substrate is characterized by a second loss tangent value for RF signals at the selected operational frequency of the second set of electronic devices that is greater than the first loss tangent value.
Example 2: The system, device or method of Example Clause 1, where the second set of electronic devices includes two or more radar transceivers configured to operate coherently using a local oscillator (LO) signal that is distributed to each radar transceiver via the second set of electrical interconnects.
Example 3: The system, device or method of Example 1 or Example 2 that further includes a set of launcher structures disposed within the carrier configured to guide RF signals away from or toward the radar transceivers.
Example 4: The system, device or method of any one of Examples 1-3, where the first set of devices are disposed on a top surface of the carrier and further includes an antenna structure mechanically coupled to a bottom surface of the carrier and configured to couple RF signals to or from the radar transceivers via the launcher structures.
Example 5: The system, device or method of any one of Examples 1-4, where the selected operational frequency of the second set of electronic devices is an LO frequency of the local oscillator; and where the second set of electrical interconnects form a passive RF power divider configured, at the LO frequency, to receive the LO signal at an input port of the power divider and distribute the LO signal to a set of output ports of the power divider.
Example 6: The system, device or method of any one of Examples 1-5 where the interposer substrate includes an amplifier that is configured to generate an amplified LO signal and to couple the amplified LO signal to the radar transceivers via the passive RF power divider.
Example 7: The system, device or method of any one of Examples 1-6 where the interposer substrate is characterized by a loss tangent value this is less than 0.01 above 10 GHz.
Example 8: The system, device or method of any one of Examples 1-7, where the RF power divider and the interposer substrate are jointly configured and arranged such that respective phases of the LO signal measured at each output of the power divider are equal to within less than five degrees.
Example 9: The system, device or method of any one of Examples 1-8, where the RF power divider is substrate-integrated waveguide (SIW) power divider.
Example 10: The system, device or method of any one of Examples 1-8, where the RF power divider is a stripline power divider.
Example 11: The system, device or method of any one of Examples 1-8, where the RF power divider is a microstrip power divider.
Example 12: The system, device or method of any one of Examples 1-8, where the RF power divider is a coplanar waveguide power divider.
Example 13: The system, device or method of any one of Examples 1-8, where the RF power divider is a hollow conductive waveguide power divider.
Example 14: The system, device or method of any one of Examples 1-8, where the RF power divider is a dielectric waveguide power divider.
Example 15: The system, device or method of any one of Examples 1-8, where the RF power divider is a coaxial power divider.

The preceding detailed description and Figures referenced therein are examples. They are illustrative in nature and are not intended to limit the embodiments of the Disclosure and uses of such embodiments. It should therefore be understood that embodiments of this Disclosure are not limited in their application to the details of construction and the arrangement of components set forth in the preceding Description or illustrated in the accompanying Figures.

The connecting lines shown in the various figures contained herein are intended to represent exemplary functional relationships and/or physical couplings between the various elements. It should be noted that many alternative or additional functional relationships or physical connections may be present in one or more embodiments of this Disclosure.

As used herein, the word "exemplary" means "serving as an example, instance, or illustration." Any implementation described herein as exemplary is not necessarily to be construed as preferred or advantageous over other implementations. Furthermore, there is no intention to be bound by any expressed or implied theory presented in the preceding technical field, background, or detailed description. It is to be understood that other phraseology and terminology used herein is for the purpose of description and should not be regarded as limiting.

The terms "comprise," "include," "have" and any variations thereof, are intended to cover non-exclusive inclusions, such that a process, method, article, or apparatus that comprises a list of elements is not necessarily limited to those elements but may include other elements not expressly listed or inherent to such process, method, article, or apparatus. Herein, "A, B, and/or C" is defined as "A or B or C" or any combination of A, B, or C.

As used herein, unless expressly stated otherwise, "connected" means that one element is directly joined to (or directly communicates with) another element in an electrical or non-electrical manner, and not necessarily mechanically. Likewise, unless expressly stated otherwise, "coupled" means that one element is directly or indirectly joined to (or directly or indirectly communicates with) another element in an electrical or non-electrical manner, and not necessarily mechanically. Thus, although the schematic illustrations of the figures may depict exemplary arrangements of elements, additional intervening elements, devices, features, or components may be present in one or more embodiments of the depicted subject matter.

The terms "first," "second" and other such numerical terms referring to structures do not imply a sequence or order unless clearly indicated by the context. Thus, the terms "first," "second," "third," "fourth" and the like in the description and the claims, if any, may be used for distinguishing between similar elements and not necessarily for describing a particular sequential or chronological order. It is to be understood that numerical terms used herein are interchangeable under appropriate circumstances such that the embodiments of the invention described herein are, for example, capable of operation in sequences other than those illustrated or otherwise described herein.

It will be appreciated that the steps of various processes described herein are non-limiting examples of suitable processes according to embodiments and are for the purposes of illustration. Systems and devices according to embodiments herein may use any suitable processes including those that omit steps described above, perform those steps and similar steps in different orders, and the like. It will also be appreciated that well-known process steps may be omitted for clarity.

As used herein the terms "approximate," "approximately," "substantial" and "substantially" mean sufficient to accomplish the stated purpose in a practical manner and that minor imperfections, if any, are not significant for the stated purpose. Along these lines, when used with references to measurable quantities including, but not limited to, dimensions, these terms mean that the quantities are equal to the values stated subject to accepted tolerances of any methods or apparatus chosen to fabricate the described structures or measure the quantities or dimensions described.

While at least one exemplary embodiment has been presented in the foregoing detailed description, it should be appreciated that a vast number of variations exist. It should also be appreciated that example embodiments described herein are not intended to limit the scope, applicability, or configuration of the claimed subject matter in any way. Rather, the foregoing detailed description will provide those skilled in the art with a convenient road map for implementing the described embodiment or embodiments. It should be understood that various changes can be made in the function and arrangement of elements without departing from the scope defined by the claims, which includes known equivalents and foreseeable equivalents at the time of filing this patent application.

## Claims

1. A system comprising:
a circuit substrate providing a first set of electrical interconnects;
a first set of electronic devices and a second set of electronic devices that are mechanically coupled to the circuit substrate, wherein the first set of electronic devices is configured to communicate with the second set of electronic devices via the first set of electrical interconnects; and
an interposer substrate mechanically and electrically coupled to the circuit substrate that provides a second set of electrical interconnects configured to route radiofrequency (RF) signals to the second set of electronic devices;
wherein the interposer substrate is **characterized by** a loss tangent value for RF signals at a selected operational frequency of the second set of electronic devices; and
wherein the circuit substrate is **characterized by** a second loss tangent value for RF signals at the selected operational frequency of the second set of electronic devices that is greater than the first loss tangent value.

2. The system of Claim 1, wherein the second set of electronic devices includes two or more radar transceivers configured to operate coherently using a local oscillator, LO, signal that is distributed to each radar transceiver via the second set of electrical interconnects.

3. The system of Claim 2, wherein the system further comprises a set of launcher structures disposed within the carrier configured to guide RF signals away from or toward the radar transceivers.

4. The system of Claim 3, wherein the first set of devices are disposed on a top surface of the carrier and the system further comprises an antenna structure mechanically coupled to a bottom surface of the carrier and configured to couple RF signals to or from the radar transceiver via the launcher structures.

5. The system of any of Claims 2 to 4, wherein the selected operational frequency of the second set of electronic devices is an LO frequency of the local oscillator; and
wherein the second set of electrical interconnects form a passive RF power divider configured, at the LO frequency, to receive the LO signal at an input port of the power divider and distribute the LO signal to a set of output ports of the power divider.

6. The system of Claim 5 wherein the interposer substrate includes an amplifier that is configured to generate an amplified LO signal and to couple the amplified LO signal to the radar transceivers via the passive RF power divider.

7. The system of Claim 5 of 6 wherein the interposer substrate is **characterized by** a loss tangent value this is less than 0.01 at a frequency greater than 10 GHz.

8. The system of any of Claims 5 to 7 wherein the RF power divider and the interposer substrate are jointly configured and arranged such that respective phases of the LO signal measured at each output of the power divider are equal to within less than five degrees.

9. The system of any of Claims 5 to 8 wherein the RF power divider is substrate-integrated waveguide, SIW, coupler.

10. The system of any of Claims 5 to 8 wherein the RF power divider is a stripline power divider.

11. The system of any of Claims 5 to 8 wherein the RF power divider is a microstrip power divider.

12. The system of any of Claims 5 to 8, wherein the RF power divider is a coplanar waveguide power divider.

13. The system of any of Claims 5 to 8, wherein the RF power divider is a hollow conductive waveguide power divider.

14. The system of any of Claims 5 to 8, wherein the RF power divider is a dielectric waveguide power divider.

15. The system of any of Claims 5 to 8, wherein the RF power divider is a coaxial power divider.
